# EUROPÄISCHE PATENTANMELDUNG

(11) **EP 2 148 376 A2**
(43) Veröffentlichungstag der Anmeldung: **27.01.2010**
(21) Anmeldenummer: 09009354.3
(22) Anmeldetag: 17.07.2009
(51) Int. Cl.: H01L 31/05, H01L 31/18

(54) **Verfahren und Vorrichtung zum Verschalten von Solarzellen in einem Photovoltaikmodul**

(30) Priorität: 21.07.2008 DE 102008034080; 19.03.2009 DE 102009013524
(71) Anmelder: Robert Bürkle GmbH, 72250 Freudenstadt (DE)
(72) Erfinder: Damm, Norbert, 76689 Karlsdorf-Neuthard (DE); Pojtinger, Michael, 72270 Baiersbronn (DE)
(74) Vertreter: Lemcke, Brommer & Partner

(57) **Zusammenfassung**

Die Erfindung betrifft ein Verfahren und eine Vorrichtung zum Verschalten von Solarzellen 6 in einem Photovoltaikmodul. Hierfür wird ein elektrisch leitendes Kontaktband 8 zum elektrischen Verschalten von zwei oder mehr Solarzellen 6 verwendet, wobei zunächst ein thermisch aktivierbarer Leitkleber 7 auf die elektrischen Kontaktierungselemente der beteiligten Solarzellen 6 aufgebracht und auf diesen Leitkleber 7 das Kontaktband 8 aufgelegt wird. Durch Zuführen von Wärme wird der Leitkleber 7 aktiviert, um das Kontaktband 8 leitend an den elektrischen Kontaktierungselementen der Solarzelle 6 festzulegen. Erfindungsgemäß erfolgt das Aktiveren des Leitklebers 7 durch ein gezieltes Erwärmen des Kontaktbandes 8, insbesondere mittels Durchleitens eines Kurzschlussstroms.

## Beschreibung

Die Erfindung betrifft ein Verfahren zum Verschalten von Solarzellen in einem Photovoltaikmodul nach dem Oberbegriff des Anspruchs 1 sowie eine Vorrichtung zur Durchführung dieses Verfahrens nach dem Oberbegriff des Anspruchs 9.

Bei einem Verfahren und einer Vorrichtung der vorliegenden Art wird ein elektrisch leitendes Kontaktband zum elektrischen Verschalten von zwei oder mehr Solarzellen mit einem thermisch aktivierbaren Leitkleber auf elektrische Kontaktierungselemente der beteiligten Solarzellen aufgebracht. Sodann wird der Leitkleber durch Zuführen von Wärme aktiviert, um das Kontaktband leitend an den elektrischen Kontaktierungselementen der Solarzellen festzulegen und diese hierdurch miteinander zu verschalten.

Photovoltaikmodule bestehen üblicherweise aus einer Anzahl von zu einem Verbund zusammengeschalteten Solarzellen, die in eine transparente Kunststoffschicht eingebettet sind, einer Glasplatte auf der sonnenzugewandten Seite des Solarzellenverbundes, einer witterungsfesten Rückseitenkaschierung, die auf die transparente Kunststoffschicht mit den Solarzellen auflaminiert wird, und einem Profilrahmen zum Schutz der Kanten. Die transparente Kunststoffschicht, in der der Solarzellenverbund eingebettet ist, besteht üblicherweise aus einem wärmeaktivierbaren Adhäsivstoff, beispielsweise aus Äthylenvinylacetat, und sorgt nach einem Laminierprozess unter Druck- und Wärmeeinwirkung für eine witterungsfeste und feuchtigkeitsdichte Verbindung der Einzelteile des Photovoltaikmoduls.

Zur Herstellung des Solarzellenverbundes müssen die einzelnen Metallisierungen der Solarzelle, bzw. deren Kontaktierungselemente im vorgegebenen Schaltbild elektrisch leitend untereinander verbunden werden, so dass letztendlich alle Solarzellen des Verbundes in einem Stromkreis verschaltet sind, der über eine Steckerbuchse an der Rückseite oder der Außenseite des Photovoltaikmoduls mit einem Verbraucher geschlossen werden kann. Diese Verschaltung der einzelnen Solarzellen untereinander erfolgt über elektrisch leitende Kontaktbänder, meist verzinkte Kupferbänder mit entsprechend der zu erwartenden Stromstärken dimensioniertem Querschnitt.

Das Aufbringen eines Kontaktbands auf die elektrischen Kontaktierungselemente der jeweilig beteiligten Solarzellen erfolgt über einen thermisch aktivierbaren Leitkleber, dessen Klebeeigenschaften durch Zuführen und Halten von Wärme eingestellt wird. Ein solcher meist pastös vorliegender Leitkleber wird zunächst auf die Kontaktierungselemente der Solarzellen aufgetragen und dann das Kontaktband aufgelegt. Soweit ein vernetzender Leitkleber verwendet wird, benötigt die Anregung der Polymerreaktion typischerweise eine Temperatur von etwa 100 bis 120 °C, während für das Aushärten eine Haltetemperatur von typischerweise ca. 140 bis 160 °C bei einer Einwirkdauer von ca. 10 bis 20 Minuten notwendig ist. Das Laminieren der Photovoltaikmodule setzt einen vollständig ausgehärteten Leitkleber voraus, da aus einer unvollständig vernetzten Kleberschicht prozesskritische, bleibende Gasblasen im Modul erzeugt würden.

Nach dem derzeitigen Stand der Technik wird das vorliegende Verfahren solcherart durchgeführt, dass zunächst ein Leitkleber auf die Kontaktierungselemente der Solarzellen aufgebracht und das Kontaktband auf den Leitkleber aufgelegt wird. Sodann wird das Kontaktband auf dem Leitkleber bzw. auf den beteiligten Solarzellen und der Glasplatte mit Klebestreifen fixiert. Der so vorbereitete, auf der Glasplatte aufliegende oder - im Falle von Dünnschichtsolarzellen - auf der Substratplatte befindliche Solarzellenverbund wird nachfolgend in einen eigens für die Leitkleberhärtung vorgesehenen Ofen verbracht, wo der Leitkleber aktiviert und gehärtet wird. Davon abgesehen, dass fertig metallisierte und kontaktierte Solarzellen möglichst wenig thermisch behandelt werden sollten, um keine Verunreinigungen in das Halbleitermaterial einzubringen, ist das Aufheizen des (halbfertigen) Moduls auf die Aushärtetemperatur des Leitklebers (also auf um die 150 °C) auch unter energetischen Gesichtspunkten und somit vom Kostenaufwand bei der Produktion her nicht optimal. Schließlich benötigt der Aushärteofen wegen der relativ langen Aushärtedauer einen nicht unerheblichen Raum am Produktionsstandort. Um reproduzierbare, konstante Prozessbedingungen bei der Weiterverarbeitung der Photovoltaikmodule zu gewährleisten, müssen diese zudem vor dem Weiterprozessieren wieder kontrolliert abgekühlt werden. Schließlich ergibt sich durch das Aufheizen und Abkühlen der Glasplatte des Photovoltaikmoduls ein thermischer Stress im Glas, der unter Umständen beim weiteren Prozessieren zu Glasbruch führen kann.

Der vorliegenden Erfindung liegt daher die Aufgabe zugrunde, ein Verfahren und eine Vorrichtung der eingangs genannten Art hinsichtlich der genannten Probleme zu verbessern, also die thermische Belastung der verschiedenen Elemente des Photovoltaikmoduls in Grenzen zu halten und die Gefahr eines Glasbruchs zu verringern.

Gelöst ist diese Aufgabe durch ein Verfahren mit den Merkmalen des Anspruchs 1 sowie durch eine Vorrichtung mit den Merkmalen des Anspruchs 9. Vorteilhafte Weiterbildungen des erfindungsgemäßen Verfahrens finden sich in den Ansprüchen 2 bis 8; bevorzugte Ausgestaltungen der erfindungsgemäßen Vorrichtung sind in den Ansprüchen 10 bis 17 niedergelegt.

Die vorliegende Erfindung unterscheidet sich vom bisherigen Stand der Technik also vornehmlich dadurch, dass das Aktivieren des Leitklebers zwischen dem Kontaktband und den Kontaktierungselementen der beteiligten Solarzellen durch ein gezieltes Erwärmen des Kontaktbandes erfolgt. Dadurch, dass die Wärme in das Kontaktband eingebracht wird, und von dort in den Leitkleber fließt, also an diejenige Stelle, an der die Wärme benötigt wird, bleiben die restlichen Teile des Photovoltaikmoduls, in diesem Stadium des Herstellungsprozesses also insbesondere die Solarzellen und die Glasplatte, thermisch unbelastet. Das Kontaktband selbst ist thermisch unempfindlich, so dass die beschriebenen bisherigen Problemstellungen des Verfahrens gelöst sind.

Um die Wärme gezielt in das Kontaktband einzubringen, kann vorgesehen sein, auf das Kontaktband ein elektrisches Widerstands-Heizelement, insbesondere einen Heizdraht, aufzulegen, und zwar solcherart, dass eine wärmeleitende Verbindung zwischen dem Heizelement und dem Kontaktband hergestellt wird, diese beiden Bauteile jedoch gegeneinander elektrisch isoliert sind. Auf diese Weise kann das Widerstands-Heizelement durch Einleiten von Strom sehr leicht und kontrolliert erhitzt werden und die Wärme gezielt an das Kontaktband abgeben. Da das Widerstands-Heizelement sehr genau gefertigt sein kann, ergeben sich hinsichtlich des elektrischen Widerstands und des über die gesamte Länge konstanten Querschnitts des Widerstandselements reproduzierbare Ergebnisse für die mit einer bestimmten Strommenge erzeugte Temperatur. Bei Bedarf ist es auch möglich, im Widerstands-Heizelement einen Temperatursensor zu integrieren, um den Prozess kontrolliert überwachen und führen zu können.

Vorzugsweise wird das elektrische Widerstands-Heizelement mit einer Zugeinrichtung auf Spannung gehalten, um wärmebedingte Längenausdehnungen zu kompensieren. Diese Zugspannung wirkt sich auch auf das direkt unter dem Heizelement liegende Kontaktband, so dass auch bei diesem keine wärmebedingte Wellenbildung oder ungleichmäßige Verklebung entstehen kann.

Als Widerstands-Heizelement kann ein Heizdraht aus elektrisch isoliertem Federstahl verwendet werden, der sehr einfach und schnell getauscht werden kann, wenn er beispielsweise durch Kleberreste verschmutzt worden ist. Denkbar wäre auch, einen solchen Heizdraht auf einer Rolle vorzuhalten und regelmäßig automatisch weiterzutakten, um solchen Verschmutzungen vorzubeugen.

Besonders bevorzugt ist es im Rahmen der vorliegenden Erfindung, wenn das Kontaktband mittels Durchleiten eines Kurzschlussstroms erwärmt wird. Hierdurch nutzt man also den Ohmschen Widerstand des Kontaktbands aus, um dieses zu erhitzen. Ein auf den Leitungsquerschnitt des entsprechenden Kontaktbandes abgestimmter Kurzschlussstrom kann durch Widerstanderwärmung innerhalb weniger Sekunden Temperaturen von 150 bis 180 °C erzeugen.

Neben dem großen Vorteil, dass hierdurch sehr einfach, nämlich durch elektrische Kontaktierung der Kontaktbänder, die erfindungsgemäß gezielte Erwärmung derselben auf die benötigte Temperatur erreicht werden kann, ergibt sich der weitere Vorteil, dass die benötigte Temperatur extrem schnell erreicht werden kann, beispielsweise in einem Zeitintervall von etwa 10 Sekunden, was einem Temperaturgradienten von ca. 1000 °C/min entspricht. Besonders vorteilhaft ist dies deswegen, da viele thermisch aktivierbare Klebersysteme, soweit sie vernetzend sind, unter großen Temperaturgradienten schneller polymerisieren als unter kleinen Temperaturgradienten.

Um die thermische Belastung der Solarzellen und der Glasplatte so klein wie möglich zu halten, sowie für eine einfachere Regelung des per Kurzschlussstrom in das Kontaktband eingebrachten Wärme ist es bevorzugt, dass der Kurzschlussstrom in mehreren aufeinanderfolgenden Stromstößen durch das Kontaktband geleitet wird, und zwar insbesondere mit einer Zeitdauer von ca. 1 Sekunde bis ca. 10 Sekunden. Auch wenn ein Widerstands-Heizelement verwendet wird, um das Kontaktband indirekt durch einen Heizstrom zu erwärmen, können Stromstöße der oben genannten Art vorgesehen sein.

Insbesondere bei Dünnschichtsolarzellen, die bereits seriell untereinander verschaltet sind, ist es zur Vermeidung von Schäden vorteilhaft, wenn die beiden Kontaktbänder der einzelnen Dünnschichtmodule mit abwechselnden Stromstößen beaufschlagt oder nacheinander aufgeheizt werden, also niemals beide Kontaktbänder gleichzeitig bestromt oder aufgeheizt werden.

Unabhängig davon, ob die Erwärmung des Kontaktbandes mittels Durchleiten eines Stroms oder auf andere Weise erfolgt, kann diese Erwärmung auf eine Temperatur vorgenommen werden, die höher liegt als die bisher für die Aktivierung bzw. Aushärtung der Leitkleber verwendete Temperatur, ohne dass die Solarzellen oder die Glasplatte Schaden nehmen; denn diese werden hierbei nicht oder nur kaum erwärmt. Durch diese möglichen höheren Temperaturen verkürzt sich die Aushärtezeit der üblichen Leitkleber nochmals, was die Prozessdauer naturgemäß verringert. Soweit die Erwärmung des Kontaktbandes mittels Durchleiten eines Kurzschlussstroms oder mittels eines aufgelegten Widerstands-Heizelements erfolgt, ist es bevorzugt, Kurzschlussströme oder Heizströme mit einer Stromstärke von ca. 10A bis 100A zu verwenden.

Da sich das Kontaktband bei Erwärmung ausdehnt, ist es im Rahmen der vorliegenden Erfindung bevorzugt, einen Niederhalter zu verwenden, der das Kontaktband zumindest während des Erwärmens auf den Leitkleber drückt und hierdurch ein Aufwölben des Kontaktbandes verhindert. Dieser Niederhalter überdeckt das Kontaktband vorzugsweise im Wesentlichen ganzflächig und besteht aus elektrisch nichtleitendem, temperaturbeständigem Material, also beispielsweise einem Kunststoff (z.B. PTFE oder PEEK). Die elektrisch nicht leitende Ausbildung des Niederhalters ermöglicht eine Kombination desselben mit der bevorzugten erfindungsgemäßen Verfahrensvariante, bei der das Kontaktband mittels Durchleitens eines Kurzschlussstroms erwärmt wird. Denn die Elektroden zum Durchleiten des Kurzschlussstroms durch das Kontaktband können dann insbesondere in den Niederhalter integriert sein, so dass sich eine separate Kontaktierung des Kontaktbandes erübrigt.

Die Temperatur des Kontaktbandes wird vorzugsweise durch einen Temperaturfühler überwacht, wobei der Temperaturfühler auch als Messgröße für eine Regelung der Temperatur des Kontaktbandes verwendet werden kann. Zweckmäßigerweise ist dieser Temperaturfühler am Niederhalter angebracht, soweit ein solcher vorhanden ist.

Das erfindungsgemäße gezielte Erwärmen des Kontaktbandes kann alternativ zum Durchleiten eines Kurzschlussstroms dadurch erfolgen, dass das Kontaktband durch ein daran anliegendes Heizelement mittels Wärmeleitung erwärmt wird. Ein solches Heizelement ist vorzugsweise an das Kontaktband anstellbar und von diesem abstellbar. Hierdurch kann beispielsweise das Heizelement bedarfsweise in Intervallen vom Kontaktband entfernt und wieder an dieses angelegt werden. Bevorzugterweise kann der Niederhalter, soweit ein solcher vorhanden ist, als Heizelement verwendet werden bzw. kann das Heizelement in den Niederhalter integriert werden.

Die Einbringung von Wärme in das Kontaktband durch ein daran anliegendes Heizelement bzw. ein in einen Niederhalter integriertes Heizelement kann auch zusätzlich zum Erwärmen des Kontaktbands mittels Durchleitens eines Kurzschlussstroms erfolgen. Das Heizelement sorgt dann für eine Wärmegrundlast auf das Kontaktband, die zum Beispiel den Leitkleber aktiviert. Diese Wärmegrundlast kann besonders gut über einen Temperaturfühler geregelt werden. Die Erwärmung des Kontaktbandes auf Aushärtetemperatur des Leitklebers **-** und hier vorzugsweise auf eine besonders hohe Aushärtetemperatur, um die Aushärtezeit klein zu halten - wird dann durch zusätzliches Durchleiten eines Kurzschlussstroms im Kontaktband erzeugt, gegebenenfalls mit intervallartigen Stromstößen.

Versuche der Anmelderin haben in diesem Zusammenhang gezeigt, dass die Aushärtung des Leitklebers nur zu etwa 70 bis 80 % erfolgen muss, um die nachfolgenden Prozessschritte ohne Beeinträchtigungen durchlaufen zu können. Das Kontaktband und/oder der Leitkleber lösen sich dann nicht mehr ab, und es können aus dem Leitkleber keine störenden Prozessgase mehr austreten, die im Endeffekt zu Blasen im Photovoltaikmodul führen könnten. Die Aushärtedauer und damit die Prozessdauer zum Verschalten der Solarzellen wird durch diese erfinderische Erkenntnis nochmals reduziert, wobei die Wärmebelastung der Solarzellen bzw. der Glasplatte nochmals geringer bleibt.

Insbesondere aufgrund der optional vorhandenen Niederhalter, jedoch auch schon alleine deswegen, weil die Erwärmung des Kontaktbandes sehr schnell und gegebenenfalls pulsartig erfolgt, ist ein Aufwölben des Kontaktbandes nicht mehr zu befürchten, so dass auf die bislang generell notwendigen Klebstreifen zur Fixierung des Kontaktbandes auf dem Leitkleber verzichtet werden kann.

Zwei Ausführungsbeispiele für eine erfindungsgemäß ausgestaltete Vorrichtung werden im folgenden anhand der beigefügten Zeichnungen näher beschrieben und erläutert. Es zeigen:
- Figur 1: einen schematischen Schnitt durch ein erstes Ausführungsbeispiel einer erfindungsgemäßen Vorrichtung, quer zur Transportrichtung;
- Figur 2: eine schematische Seitenansicht zur Schnittdarstellung nach Figur 1;
- Figur 3: eine schematische Seitenansicht eines zweiten Ausführungsbeispiels.

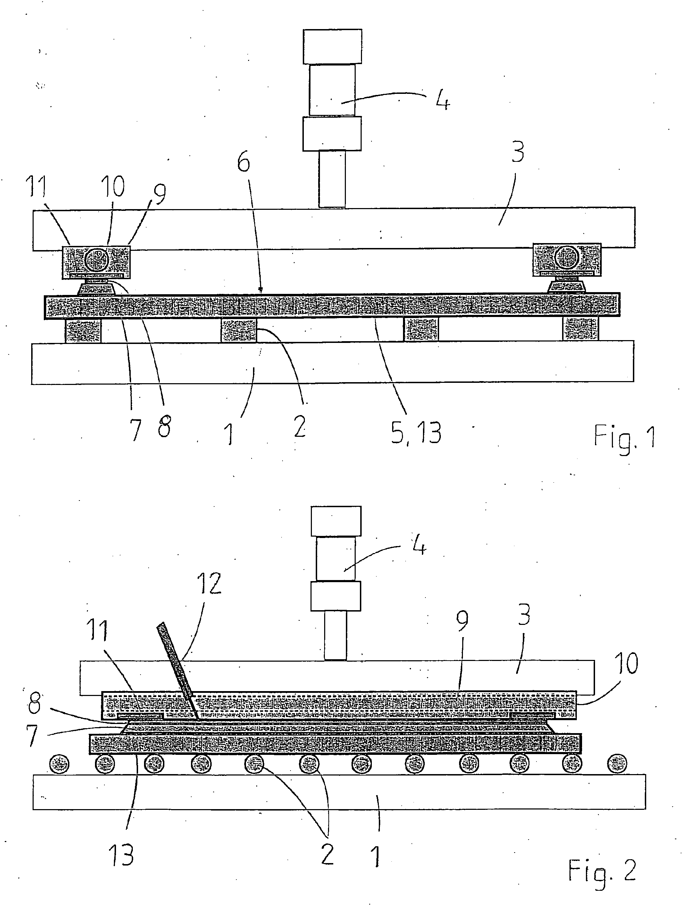

Die in Figur 1 in einer Draufsicht (in Transportrichtung des Werkstücks) dargestellte Vorrichtung besteht aus einem Tisch 1 mit einer Anzahl von darauf angeordneten Rollen 2 sowie einem beweglichen Oberteil 3, das mittels eines Fluidzylinders 4 angehoben und abgesenkt werden kann. Wenn das bewegliche Oberteil 3 angehoben ist, kann ein Photovoltaikmodul 5 auf den Rollen 2 bewegt werden, um es in die Vorrichtung einzufahren und aus dieser wieder herauszufahren. Streng genommen handelt es sich noch nicht um ein Photovoltaikmodul 5, da dieses im derzeitigen Stadium des Herstellungsverfahrens lediglich aus einem Verbund von Solarzellen 6 besteht, die auf einer Glasplatte 13 angeordnet sind und auf ihren Kontaktierungselementen, also in der Regel den Metallisierungen, mit jeweils einem pastösten Leitkleber 7 und einem darauf aufgelegten Kontaktband 8 versehen sind. Denn die Aufgabe der dargestellten Vorrichtung ist es erfindungsgemäß gerade, die Kontaktbänder 8 auf dem Modul 5 zu fixieren und hierdurch die Solarzellen 6 zu verschalten. Die Fixierung soll dabei so weit erfolgen, dass in späteren Prozessschritten bei der Herstellung des Photovoltaikmoduls, also insbesondere beim Laminieren desselben, kein mechanisches Ablösen eines Kontaktbandes 8 und/oder des Leitklebers 7 erfolgt und außerdem keine störenden Prozessgase mehr aus dem Leitkleber 7 austreten können, die in der später aufgebrachten, für den Laminierprozess wichtigen Kunststoff- bzw. Kleberschicht zu Blasen führen könnten.

Zu diesem Zweck ist die in Figur 1 dargestellte Vorrichtung mit zwei Niederhaltern 9 ausgerüstet, die, wie Figur 2 zeigt, die Kontaktbänder 8 im Wesentlichen ganzflächig abdecken und auf die Leitkleberschicht 7 aufpressen. Die Niederhalter 9 bestehen aus einem bis über 200 °C temperaturbeständigen Kunststoffmaterial, und in ihrem Inneren ist jeweils ein Heizelement 10 angebracht, das für eine Wärmegrundlast auf das Kontaktband 8 sorgt, beispielsweise mit einer Temperatur von 100 bis 150 °C im Kontaktbereich zwischen dem Niederhalter 9 und dem Kontaktband 8. Diese Temperatur wird mit einem in Figur 2 dargestellten Temperaturfühler 12 laufend gemessen, so dass das Heizelement 10 entsprechend einer vorgegebenen Solltemperatur geregelt werden kann.

Wie in Figur 2 besser zu erkennen ist, sind Elektroden 11 in die Niederhalter 9 integriert, und zwar jeweils in den beiden Endbereichen jedes Kontaktbandes 8. Mittels dieser Elektroden 11 kann ein leitender Kontakt zum Kontaktband 8 hergestellt werden, so dass ein Kurzschlussstrom durch das Kontaktband 8 geleitet werden kann, um dieses auf eine Temperatur aufzuheizen, bei der der Leitkleber 7 aktiviert und gegebenenfalls ausgehärtet wird. Dadurch, dass sich das Kontaktband 8 aufheizt, die Wärme also gezielt in das Kontaktband 8 eingebracht wird, fließt dieselbe in den direkt benachbarten Leitkleber 7, wo sie benötigt wird. Höchstens ein Bruchteil dieser Wärme gelangt in die Solarzellen 6 und über die Solarzellen 6 in die Glasplatte 13, so dass zum einen die thermische Belastung der Solarzellen 6 vorteilhaft gering bleibt und zum anderen ein thermischer Stress in der Glasplatte 13 unterbleibt.

Beim Photovoltaikmodul des vorliegenden Ausführungsbeispiels handelt es sich um ein Modul mit Dünnschichtsolarzellen, die über die Breite des Moduls lediglich mit zwei Kontaktbändern 8 verschaltet werden müssen. Die zwischenliegenden Solarzellen 6 sind bereits seriell miteinander verschaltet, so dass vorliegend die beiden Kontaktbänder 8 über die jeweiligen Elektroden 11 rechts und links abwechselnd mit Stromstößen erhitzt werden, um die Leitkleberschichten 7 zu aktivieren. Eine typische Stromstoßfolge besteht aus mehreren, 5 bis 10 s andauernden Intervallen mit Stromstärken von ca. 50 bis 100 A. Darüber hinaus sind die beiden Niederhalter 9 mit den integrierten Heizelementen 10 einzeln vom jeweiligen Kontaktband 8 weg anhebbar und auf dieses absenkbar, um die Einwirkdauer der vom Heizelement 10 herrührenden Wärmegrundlast durch Intervalle zu begrenzen.

Die für die Aktivierung der Leitkleber 7 notwendige Wärme wird demnach mit einem vorteilhaft geringen Energieaufwand bereitgestellt. Diejenigen Elemente des Moduls, die nicht unbedingt mit Wärme beaufschlagt werden müssen, werden hinsichtlich ihrer thermischen Belastung geschont. Darüber hinaus erfolgt das Aktivieren des thermisch reaktiven Leitklebers 7 durch die höheren möglichen Temperaturen an diesem Ort sowie die hohen Temperaturgradienten beim Aufheizen besonders schnell, so dass das erfindungsgemäße Verfahren den Prozessschritt des Aufbringens von Kontaktbändern 8 schließlich deutlich verkürzt. Beispielsweise kann bei Verwendung eines vernetzenden Leitklebers 7 durch Stoßerwärmung der Kontaktbänder 8 mittels Kurschluss-Stromstößen in weniger als 60 s mehr als 80 % Vernetzung des Leitklebers 7 erreicht werden, was für die nachfolgenden Prozessschritte in der Regel ausreicht.

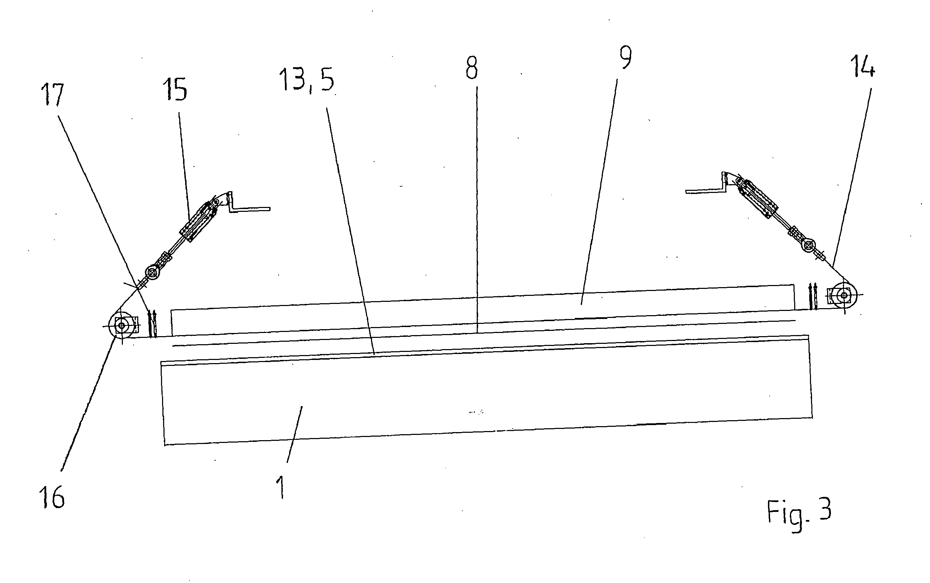

Wenn das Durchleiten von hohen Strömen durch das Kontaktband 8 vermieden werden soll, kann in einem anderen, in Figur 3 dargestellten Ausführungsbeispiel auch ein separater, mit einer elektrischen Isolierung versehener Heizdraht 14 zwischen den Niederhalter 9 und das Kontaktband 8 gelegt und mittels Durchleiten von Heizstrom über Stromkontakte 17 erhitzt werden. Da der Heizdraht 14 mit einer elektrischen Isolierung versehen ist, wird nur die Wärme des Heizdrahts 14 auf das Kontaktband 8 übertragen. Strom fließt durch das Kontaktband 8 dann nicht. Dieser Heizdraht 14 ist länger und breiter als das Kontaktband 8, so dass dieses immer komplett und gleichmäßig erwärmt wird, unabhängig von Toleranzen beim Auflegen des Kontaktbandes 8. Damit ist gewährleistet, dass die Enden des Kontaktbandes 8 sicher verklebt werden. Gleichwohl weist der Heizdraht 14 einen geringen Querschnitt auf, um eine exakte und flexible Temperaturführung zu ermöglichen.

Eine mittels zweier Pneumatikzylinder 15 und Umlenkrollen 16 gebildete Zugeinrichtung in diesem zweiten Ausführungsbeispiel hält den Heizdraht 14 unter Spannung und sorgt somit dafür, dass wärmebedingte Längenänderungen, insbesondere Ausdehnungen des Heizdrahts 14 und des Kontaktbandes 8, kompensiert werden. Da das unter dem Heizdraht 14 liegende Kontaktband 8 wegen mechanischer Reibungseffekte zusammen mit dem Heizdraht 14 auf Spannung gehalten wird, kann keine Wellenbildung oder ungleichmäßige Verklebung des Kontaktbandes 8 auftreten.

Der Heizdraht 14 besitzt einen konstanten und bekannten elektrischen Widerstand, so dass das Kontaktband 8 reproduzierbar erwärmt werden kann, ohne dass Querschnittstoleranzen des Kontaktbandes 8 Einfluss auf die Erwärmung haben können. Die Temperatur des Heizdrahtes 14 kann einfach überwacht und protokolliert werden.

Nach diesem Ausführungsbeispiel ist es nicht notwendig, mehrere Kontaktbänder 8 eines Photovoltaik-Moduls 5 abwechselnd zu erwärmen; dies kann vielmehr gleichzeitig geschehen, so dass sich die Taktzeit zur Verschaltung des Photovoltaik-Moduls 5 verkürzt.

Der Heizdraht 14 kann als elektrisch isolierter, beispielsweise unterseitig lackierter Federstahl ausgebildet sein, der bei einer etwaigen Verschmutzung durch Kleberreste einfach und schnell getauscht werden kann, so dass keine Reinigung erforderlich ist. Gegebenenfalls kann dieser Heizdraht 14 auf einer (nicht dargestellten) Rolle vorgehalten und regelmäßig automatisch weitergetaktet werden, um Verschmutzungen vorzubeugen.

## Patentansprüche

1. Verfahren zum Verschalten von Solarzellen in einem Photovoltaikmodul, wobei ein elektrisch leitendes Kontaktband (8) zum elektrischen Verschalten von zwei oder mehr Solarzellen (6) mit einem thermisch aktivierbaren Leitkleber (7) auf elektrische Kontaktierungselemente der beteiligten Solarzellen (6) aufgebracht und der Leitkleber (7) durch Zuführen von Wärme aktiviert wird, um das Kontaktband (8) leitend an den elektrischen Kontaktierungselementen festzulegen,
**dadurch gekennzeichnet,**
**dass** das Aktivieren des Leitklebers (7) durch ein gezieltes Erwärmen des Kontaktbandes (8) erfolgt.

2. Verfahren nach Anspruch 1,
**dadurch gekennzeichnet,**
**dass** das Kontaktband (8) mittels Durchleiten eines Kurzschlussstroms erwärmt wird und/oder dass das gezielte Erwärmen des Kontaktbandes (8) durch wärmeleitendes und elektrisch isoliertes Auflegen eines elektrischen Widerstands-Heizelements (14) auf das Kontaktband (8) und Durchleiten eines Heizstroms durch das Widerstands-Heizelement (14) erfolgt.

3. Verfahren nach Anspruch 2
**dadurch gekennzeichnet,**
**dass** der Kurzschlussstrom oder der Heizstrom in mehreren aufeinanderfolgenden Stromstößen durch das Kontaktband (8) oder das Widerstands-Heizelement (14) geleitet wird.

4. Verfahren nach einem der Ansprüche 2 oder 3,
**dadurch gekennzeichnet,**
**dass** mindestens zwei Kontaktbänder (8) mit abwechselnden Stromstößen beaufschlagt werden.

5. Verfahren nach mindestens einem der Ansprüche 1 bis 4,
**dadurch gekennzeichnet,**
**dass** das Kontaktband (8) während des Erwärmens mittels mindestens eines Niederhalters (9) auf den Leitkleber (7) gedrückt wird.

6. Verfahren nach mindestens einem der Ansprüche 1 bis 5,
**dadurch gekennzeichnet,**
**dass** das Kontaktband (8) durch ein Heizelement (10) mittels Wärmeleitung erwärmt wird.

7. Verfahren nach den Ansprüchen 5 und 6,
**dadurch gekennzeichnet,**
**dass** der Niederhalter (9) als Heizelement (10) verwendet wird.

8. Verfahren nach mindestens einem der Ansprüche 1 bis 7,
**dadurch gekennzeichnet,**
**dass** die Temperatur des Kontaktbandes (8) mittels eines Temperaturfühlers (12) überwacht und/oder geregelt wird.

9. Vorrichtung zum Verschalten von Solarzellen in einem Photovoltaikmodul mittels eines elektrisch leitenden Kontaktbandes (8), das mit einem thermisch aktivierbaren Leitkleber (7) auf elektrische Kontaktierungselemente der beteiligten Solarzellen (6) aufgelegt ist, mit einem Verfahren nach mindestens einem der Ansprüche 1 bis 8,
**gekennzeichnet durch** Mittel (10, 11) zum gezielten Erwärmen des Kontaktbandes (8).

10. Vorrichtung nach Anspruch 9,
**dadurch gekennzeichnet,**
**dass** die Erwärmungsmittel Elektroden (11) zum Durchleiten eines Kurzschlussstroms durch das Kontaktband (8) umfassen.

11. Vorrichtung nach einem der Ansprüche 9 oder 10,
**dadurch gekennzeichnet,**
**dass** mindestens ein Niederhalter (9) vorgesehen ist, um das Kontaktband (8) während des Erwärmens auf den Leitkleber (7) zu drücken.

12. Vorrichtung nach den Ansprüchen 10 und 11,
**dadurch gekennzeichnet,**
**dass** die Elektroden (11) in den Niederhalter (9) integriert sind.

13. Vorrichtung nach mindestens einem der Ansprüche 9 bis 12,
**dadurch gekennzeichnet,**
**dass** ein bedarfsweise auf das Kontaktband (8) auflegbares Heizelement (10) vorgesehen ist.

14. Vorrichtung nach einem der Ansprüche 11 oder 12 und Anspruch 13,
**dadurch gekennzeichnet,**
**dass** der Niederhalter (9) mit dem Heizelement (10) versehen ist.

15. Vorrichtung nach mindestens einem der Ansprüche 11 bis 14,
**dadurch gekennzeichnet,**
**dass** der Niederhalter (9) das Kontaktband (8) im Wesentlichen ganzflächig überdeckt.

16. Vorrichtung nach mindestens einem der Ansprüche 9 bis 15,
**dadurch gekennzeichnet,**
**dass** ein Temperaturfühler (12) zur Überwachung und/oder Regelung der Erwärmung des Kontaktbandes (8) vorhanden ist.

17. Vorrichtung nach Anspruch 11,
**dadurch gekennzeichnet,**
**dass** der Niederhalter (9) aus elektrisch nichtleitendem, temperaturbeständigem Material, insbesondere aus Kunststoff, besteht.
